(19) Europäisches Patentamt
European Patent Office
Office européen des brevets

(11) **EP 2 897 294 A1**

(12) **EUROPEAN PATENT APPLICATION**

(43) Date of publication:
**22.07.2015 Bulletin 2015/30**

(51) Int Cl.:
**H03M 13/11** *(2006.01)*

(21) Application number: **15151975.8**

(22) Date of filing: **21.01.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **21.01.2014 US 201461929807 P**
**31.03.2014 US 201461973084 P**
**16.01.2015 US 201514599325**

(71) Applicant: **Samsung Electronics Co., Ltd Gyeonggi-do 443-742 (KR)**

(72) Inventors:
• **Abu-Surra, Shadi**
**Plano, TX Texas 75024 (US)**
• **Pisek, Eran**
**Plano, TX Texas 75025 (US)**
• **Henige, Thomas Michael**
**Plano, TX Texas 75025 (US)**
• **Rajagopal, Sridhar**
**Plano, TX Texas 75025 (US)**

(74) Representative: **Nederlandsch Octrooibureau**
**P.O. Box 29720**
**2502 LS The Hague (NL)**

(54) **LDPC decoding using different quantization for check node and variable node processing**

(57)    A low density parity check decoder is provided that includes a variable-node (VN) processing domain comprising high-bit resolution (high-precision quantisation) processing circuitry, a check-node (CN) processing domain comprising low-bit resolution (low-precision quantisation) processing circuitry lower than the high-bit resolution processing circuitry, and mapping circuitry configured to transfer a message between the VN processing quantisation domain and the CN processing quantisation domain.

FIG.15

EP 2 897 294 A1

**Description**

**TECHNICAL FIELD**

The present application relates generally to receivers, more specifically, to receivers configured to conduct decoding for low density parity check codes.

**BACKGROUND**

In information theory, a low-density parity-check (LDPC) code is a forward error correcting code for transmitting a message over a noisy transmission channel. LDPC codes are a class of linear block codes. While LDPC codes and other forward error correcting codes cannot guarantee perfect transmission, the power needed to transmit information with reliable probability of loss is greatly minimized. LDPC codes are capacity achieving codes, which allow data transmission rates close to the theoretical maximum known as the Shannon Limit. LDPC codes can perform with 0.0045 dB of the Shannon Limit. LDPC codes are quickly becoming the favored coding method for high data rate communications, and are being used in many new and developing communications standards. Typically, the Min-Sum LDPC decoder with single quantization-domain is used for their low-complexity. The power consumption of this decoder scales linearly with the bit-precision of the quantized-domain. However, reducing the bit-precision below 5-bit greatly degrades the decoder's performance.

**SUMMARY**

This disclosure provides methods and apparatus for low-power dual quantization-domain decoding of low-density parity-check codes.

In a first embodiment, a low density parity check (LDPC) decoder is provided. The LDPC decoder includes a variable-node (VN) processing domain comprising high-bit resolution processing circuitry, a check-node (CN) processing domain comprising low-bit resolution processing circuitry lower than the high-bit resolution processing circuitry, and mapping circuitry configured to transfer a message between the VN processing domain and the CN processing domain.

In a second embodiment, a method of decoding low density parity check (LDPC) codes is provided. The method includes receiving high-bit resolution messages at a high-bit resolution variable-node (VN) processing domain, applying VN processing in the VN processing domain, mapping the high-bit resolution messages to low-bit resolution messages having a bit resolution lower than the bit resolution of the high-bit resolution messages, applying check-node (CN) processing in a low-bit resolution CN processing domain, mapping the low-bit resolution messages to high-bit resolution messages, and applying multiple iterations between the VN processing and the CN processing.

Other technical features may be readily apparent to one skilled in the art from the following figures, descriptions, and claims.

Before undertaking the DETAILED DESCRIPTION below, it may be advantageous to set forth definitions of certain words and phrases used throughout this patent document. The term "couple" and its derivatives refer to any direct or indirect communication between two or more elements, whether or not those elements are in physical contact with one another. The terms "transmit," "receive," and "communicate," as well as derivatives thereof, encompass both direct and indirect communication. The terms "include" and "comprise," as well as derivatives thereof, mean inclusion without limitation. The term "or" is inclusive, meaning and/or. The phrase "associated with," as well as derivatives thereof, means to include, be included within, interconnect with, contain, be contained within, connect to or with, couple to or with, be communicable with, cooperate with, interleave, juxtapose, be proximate to, be bound to or with, have, have a property of, have a relationship to or with, or the like. The term "controller" means any device, system or part thereof that controls at least one operation. Such a controller can be implemented in hardware or a combination of hardware and software and/or firmware. The functionality associated with any particular controller can be centralized or distributed, whether locally or remotely. The phrase "at least one of," when used with a list of items, means that different combinations of one or more of the listed items can be used, and only one item in the list may be needed. For example, "at least one of: A, B, and C" includes any of the following combinations: A, B, C, A and B, A and C, B and C, and A and B and C.

Definitions for other certain words and phrases are provided throughout this patent document. Those of ordinary skill in the art should understand that in many if not most instances, such definitions apply to prior as well as future uses of such defined words and phrases.

**BRIEF DESCRIPTION OF THE DRAWINGS**

For a more complete understanding of this disclosure and its advantages, reference is now made to the following description, taken in conjunction with the accompanying drawings, in which:

FIGURE 1 illustrates an example wireless network according to this disclosure;

FIGURES 2A and 2B illustrate example wireless transmit and receive paths according to this disclosure;

FIGURE 3 illustrates an example user equipment according to this disclosure;

FIGURES 4A and 4B illustrate example LDPC code Tanner graphs according to this disclosure;

FIGURE 5 illustrates a protograph according to this disclosure;

FIGURE 6 illustrates a "vectorized" protograph according to this disclosure;

FIGURE 7 illustrates an protograph with a cycle size 4 according to this disclosure;

FIGURE 8 illustrates an example dual quantization-domains layered low-density parity-check (LDPC) decoder according to this disclosure;

FIGURE 9 illustrates another example dual quantization-domains layered LDPC decoder according to this disclosure;

FIGURE 10 illustrates an example dual quantization-domains flooding LDPC decoder according to this disclosure;

FIGURE 11 illustrates an example variable node (VN) processor in a flooding LDPC decoder according to this disclosure;

FIGURE 12 illustrates an example Q-Adder in a flooding LDPC decoder according to this disclosure;

FIGURE 13 illustrates an example check-node (CN) processor according to this disclosure;

FIGURE 14 illustrates an example magnitude processor according to this disclosure;

FIGURE 15 illustrates an example dual quantization-domains layered LDPC decoder according to this disclosure;

FIGURE 16 illustrates another example CN processor according to this disclosure;

FIGURE 17 illustrates an example Min1,Min2 processor architecture according to this disclosure; and

FIGURE 18 illustrates an example Min1,Min2 processor architecture with programmable input according to this disclosure.

## DETAILED DESCRIPTION

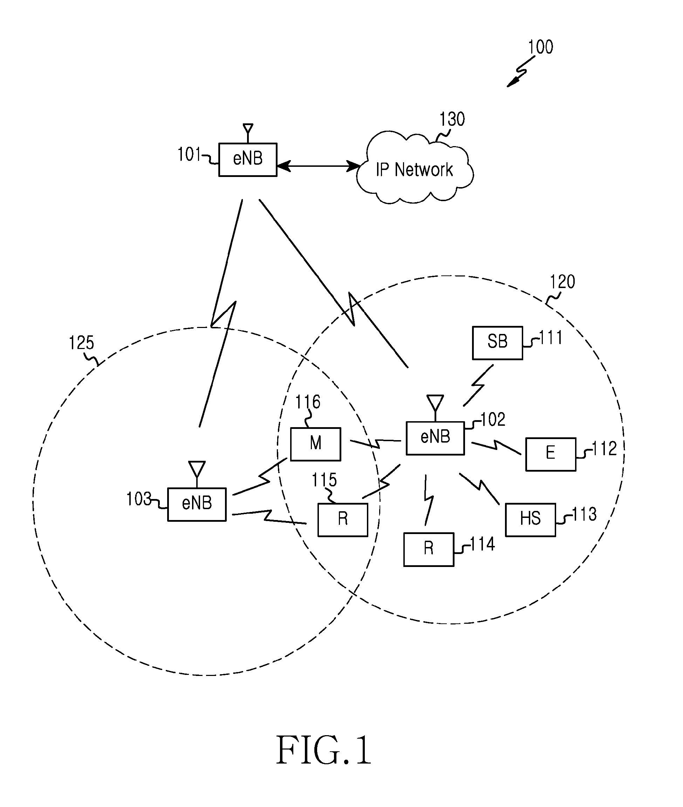

FIGURES 1 through 18, discussed below, and the various embodiments used to describe the principles of the present invention in this patent document are by way of illustration only and should not be construed in any way to limit the scope of the disclosure. Those skilled in the art will understand that the principles of this disclosure can be implemented in any suitably arranged device or system.

The following documents and standards descriptions are hereby incorporated into the present disclosure as if fully set forth herein: R. G. Gallager, Low-density parity-check codes. Cambridge, MA: MIT Press, 1963 (REF 1); IEEE 802.16e (REF 2); IEEE 802.15c (REF 3); DVB-S2 (REF 4); R. M. Tanner, "A recursive approach to low complexity codes," IEEE Trans. on Inform. Theory, vol. 27, pp. 533-547, September 1981 (REF 5); J. Thorpe, "Low-density parity-check (LDPC) codes constructed from protographs," Tech. Rep. 42-154, IPN Progress Report, August 2003 (REF 6); D. Divsalar, S. Dolinar, and C. Jones, "Protograph LDPC codes over burst erasure channels," IEEE Military Common. Conf., MILCOM 2006 (REF7); G. Liva, and M. Chiani "Protograph LDPC Codes Design Based on EXIT Analysis," IEEE Global Telecommunication Conference, GLOBECOM 2007 (REF 8); PEG (REF 9); S U.S. Patent 8,627,166B2 entitled "LDPC Code Family for Millimeter-Wave Band Communications in a Wireless Network" (REF 10); U.S. Patent Publication 2013/0061114A1 entitled "Freezing-based LDPC Decoder and Method" (REF 11); and U.S. Patent 8,458,556 B2 entitled "Low Complexity Finite Precision Decoders and Apparatus for LDPC Codes," (REF 12).

FIGURE 1 illustrates an example wireless network 100 according to this disclosure. The embodiment of the wireless network 100 shown in FIGURE 1 is for illustration only. Other embodiments of the wireless network 100 could be used without departing from the scope of this disclosure.

As shown in FIGURE 1, the wireless network 100 includes an eNodeB (eNB) 101, an eNB 102, and an eNB 103. The eNB 101 communicates with the eNB 102 and the eNB 103. The eNB 101 also communicates with at least one Internet Protocol (IP) network 130, such as the Internet, a proprietary IP network, or other data network.

Depending on the network type, other well-known terms may be used instead of "eNodeB" or "eNB," such as "base station" or "access point." For the sake of convenience, the terms "eNodeB" and "eNB" are used in this patent document to refer to network infrastructure components that provide wireless access to remote terminals. Also, depending on the network type, other well-known terms may be used instead of "user equipment" or "UE," such as "mobile station," "subscriber station," "remote terminal," "wireless terminal," or "user device." For the sake of convenience, the terms "user equipment" and "UE" are used in this patent document to refer to remote wireless equipment that wirelessly accesses an eNB, whether the UE is a mobile device (such as a mobile telephone or smartphone) or is normally considered a stationary device (such as a desktop computer or vending machine).

The eNB 102 provides wireless broadband access to the network 130 for a first plurality of user equipments (UEs) within a coverage area 120 of the eNB 102. The first plurality of UEs includes a UE 111, which can be located in a small business (SB); a UE 112, which can be located in an enterprise (E); a UE 113, which can be located in a WiFi hotspot (HS); a UE 114, which can be located in a first residence (R); a UE 115, which can be located in a second residence (R); and a UE 116, which can be a mobile device (M) like a cell phone, a wireless laptop, a wireless PDA, or the like. The eNB 103 provides wireless broadband access to the network 130 for a second plurality of UEs within a coverage area 125 of the eNB 103. The second plurality of UEs includes the UE 115 and the UE 116. In some embodiments, one or more of the eNBs 101-103 can communicate with each other and with the UEs 111-116 using 5G, LTE, LTE-A, WiMAX, or other advanced wireless communication techniques.

Dotted lines show the approximate extents of the coverage areas 120 and 125, which are shown as approximately circular for the purposes of illustration and explanation only. It should be clearly understood that the coverage areas associated with eNBs, such as the coverage areas 120 and 125, can have other shapes, including irregular shapes, depending upon the configuration of the eNBs and variations in the radio environment associated with natural and man-made obstructions.

As described in more detail below, at least one receiver, such as a receiver of a UE 116, is configured to conduct dual quantization-domain decoding for low density parity check codes. Additionally, one or more of eNBs 101-103 are configured to support operations for dual quantization-domain decoding for low density parity check codes.

Although FIGURE 1 illustrates one example of a wireless network 100, various changes can be made to FIGURE 1. For example, the wireless network 100 could include any number of eNBs and any number of UEs in any suitable arrangement. Also, the eNB 101 could communicate directly with any number of UEs and provide those UEs with wireless broadband access to the network 130. Similarly, each eNB 102-103 could communicate directly with the network 130 and provide UEs with direct wireless broadband access to the network 130. Further, the eNB 101, 102, and/or 103 could provide access to other or additional external networks, such as external telephone networks or other types of data networks.

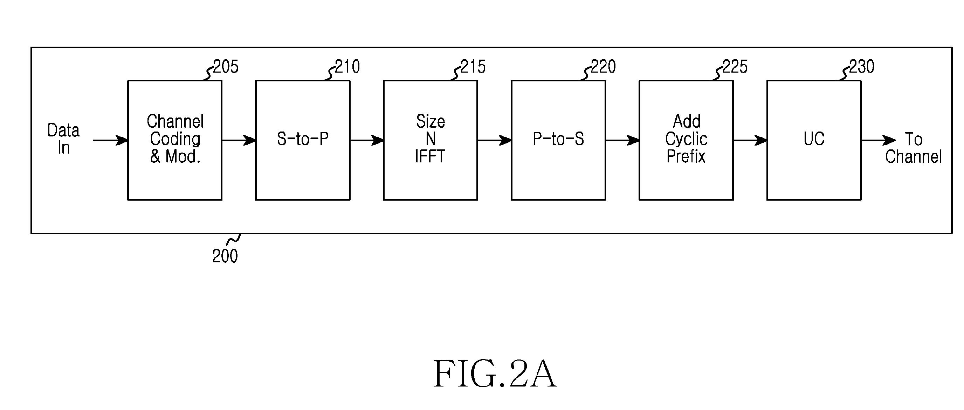

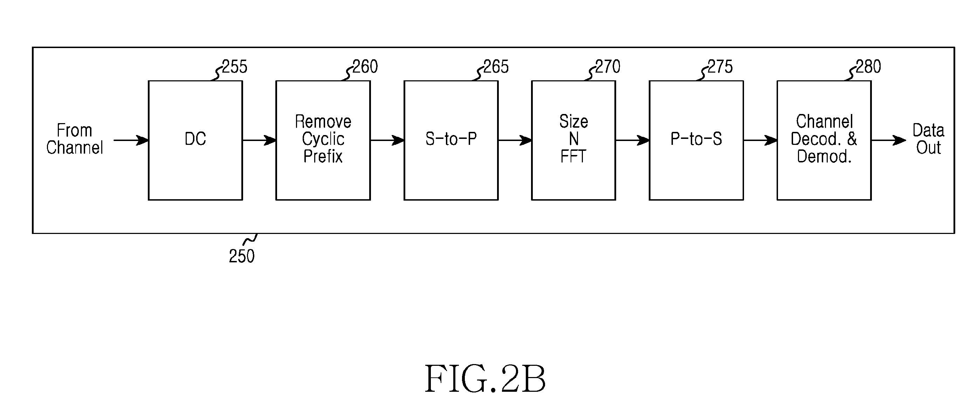

FIGURES 2A and 2B illustrate example wireless transmit and receive paths according to this disclosure. In the following description, a transmit path 200 can be described as being implemented in an eNB (such as eNB 102), while a receive path 250 can be described as being implemented in a UE (such as UE 116). However, it will be understood that the receive path 250 could be implemented in an eNB and that the transmit path 200 could be implemented in a UE. In some embodiments, processing circuitry within, or coupled to, the transmit path 200 and receive path 250 are configured to conduct dual quantization-domain decoding for low density parity check codes.

The transmit path 200 includes a channel coding and modulation block 205, a serial-to-parallel (S-to-P) block 210, a size N Inverse Fast Fourier Transform (IFFT) block 215, a parallel-to-serial (P-to-S) block 220, an add cyclic prefix block 225, and an up-converter (UC) 230. The receive path 250 includes a down-converter (DC) 255, a remove cyclic prefix block 260, a serial-to-parallel (S-to-P) block 265, a size N Fast Fourier Transform (FFT) block 270, a parallel-to-serial (P-to-S) block 275, and a channel decoding and demodulation block 280.

In the transmit path 200, the channel coding and modulation block 205 receives a set of information bits, applies coding (such as a low-density parity check (LDPC) coding), and modulates the input bits (such as with Quadrature Phase Shift Keying (QPSK) or Quadrature Amplitude Modulation (QAM)) to generate a sequence of frequency-domain modulation symbols. The serial-to-parallel block 210 converts (such as de-multiplexes) the serial modulated symbols to parallel data in order to generate N parallel symbol streams, where N is the IFFT/FFT size used in the eNB 102 and the UE 116. The size N IFFT block 215 performs an IFFT operation on the N parallel symbol streams to generate time-domain output signals. The parallel-to-serial block 220 converts (such as multiplexes) the parallel time-domain output symbols from the size N IFFT block 215 in order to generate a serial time-domain signal. The add cyclic prefix block 225 inserts a cyclic prefix to the time-domain signal. The up-converter 230 modulates (such as up-converts) the output of the add cyclic prefix block 225 to an RF frequency for transmission via a wireless channel. The signal can also be filtered at baseband before conversion to the RF frequency.

A transmitted RF signal from the eNB 102 arrives at the UE 116 after passing through the wireless channel, and reverse operations to those at the eNB 102 are performed at the UE 116. The down-converter 255 down-converts the received signal to a baseband frequency, and the remove cyclic prefix block 260 removes the cyclic prefix to generate a serial time-domain baseband signal. The serial-to-parallel block 265 converts the time-domain baseband signal to parallel time domain signals. The size N FFT block 270 performs an FFT algorithm to generate N parallel frequency-domain signals. The parallel-to-serial block 275 converts the parallel frequency-domain signals to a sequence of modulated data symbols. The channel decoding and demodulation block 280 demodulates and decodes the modulated symbols to recover the original input data stream.

Each of the eNBs 101-103 can implement a transmit path 200 that is analogous to transmitting in the downlink to UEs 111-116 and can implement a receive path 250 that is analogous to receiving in the uplink from UEs 111-116. Similarly, each of UEs 111-116 can implement a transmit path 200 for transmitting in the uplink to eNBs 101-103 and can implement a receive path 250 for receiving in the downlink from eNBs 101-103.

Each of the components in FIGURES 2A and 2B can be implemented using only hardware or using a combination of hardware and software/firmware. As a particular example, at least some of the components in FIGURES 2A and 2B can be implemented in software, while other components can be implemented by configurable hardware or a mixture of software and configurable hardware. For instance, the FFT block 270 and the IFFT block 215 can be implemented as configurable software algorithms, where the value of size N can be modified according to the implementation.

Furthermore, although described as using FFT and IFFT, this is by way of illustration only and should not be construed to limit the scope of this disclosure. Other types of transforms, such as Discrete Fourier Transform (DFT) and Inverse Discrete Fourier Transform (IDFT) functions, could be used. It will be appreciated that the value of the variable N can be any integer number (such as 1, 2, 3, 4, or the like) for DFT and IDFT functions, while the value of the variable N can be any integer number that is a power oftwo (such as 1, 2, 4, 8, 16, or the like) for FFT and IFFT functions.

Although FIGURES 2A and 2B illustrate examples of wireless transmit and receive paths, various changes can be made to FIGURES 2A and 2B. For example, various components in FIGURES 2A and 2B could be combined, further subdivided, or omitted and additional components could be added according to particular needs. Also, FIGURES 2A and 2B are meant to illustrate examples of the types of transmit and receive paths that could be used in a wireless network. Any other suitable architectures could be used to support wireless communications in a wireless network.

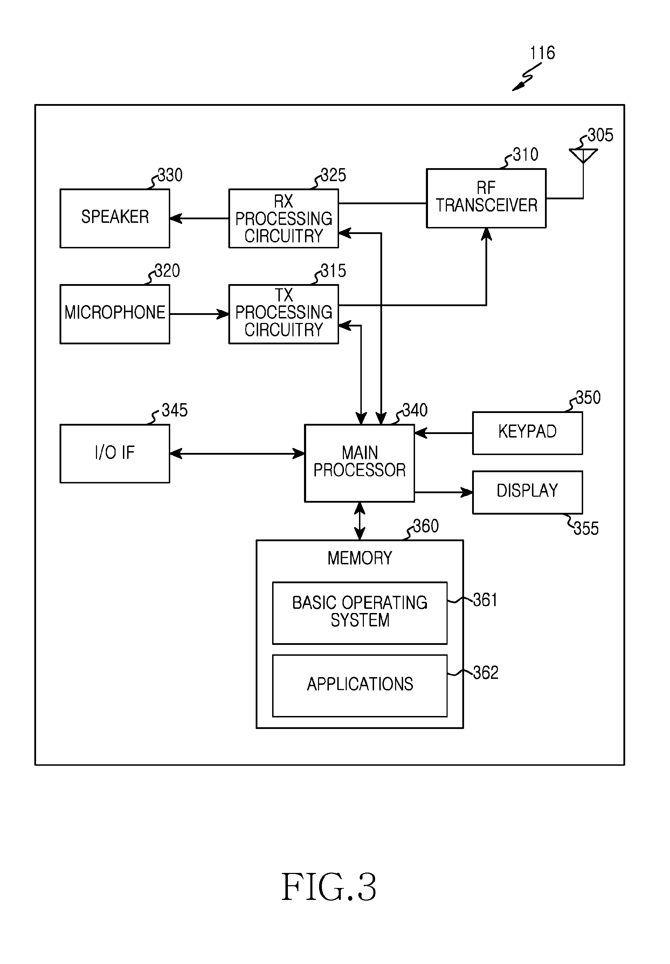

FIGURE 3 illustrates an example UE 116 according to this disclosure. The embodiment of the UE 116 illustrated in FIGURE 3 is for illustration only, and the UEs 111-115 of FIGURE 1 could have the same or similar configuration. However, UEs come in a wide variety of configurations, and FIGURE 3 does not limit the scope of this disclosure to any particular implementation of a UE.

As shown in FIGURE 3, the UE 116 includes an antenna 305, a radio frequency (RF) transceiver 310, transmit (TX) processing circuitry 315, a microphone 320, and receive (RX) processing circuitry 325. The UE 116 also includes a speaker 330, a main processor 340, an input/output (I/O) interface (IF) 345, a keypad 350, a display 355, and a memory 360. The memory 360 includes a basic operating system (OS) program 361 and one or more applications 362.

The RF transceiver 310 receives, from the antenna 305, an incoming RF signal transmitted by an eNB of the network 100. The RF transceiver 310 down-converts the incoming RF signal to generate an intermediate frequency (IF) or baseband signal. The IF or baseband signal is sent to the RX processing circuitry 325, which generates a processed baseband signal by filtering, decoding, and/or digitizing the baseband or IF signal. The RX processing circuitry 325 transmits the processed baseband signal to the speaker 330 (such as for voice data) or to the main processor 340 for further processing (such as for web browsing data).

The TX processing circuitry 315 receives analog or digital voice data from the microphone 320 or other outgoing baseband data (such as web data, e-mail, or interactive video game data) from the main processor 340. The TX processing circuitry 315 encodes, multiplexes, and/or digitizes the outgoing baseband data to generate a processed baseband or IF signal. The RF transceiver 310 receives the outgoing processed baseband or IF signal from the TX processing circuitry 315 and up-converts the baseband or IF signal to an RF signal that is transmitted via the antenna 305.

The main processor 340 can include one or more processors or other processing devices and execute the basic OS program 361 stored in the memory 360 in order to control the overall operation of the UE 116. For example, the main processor 340 could control the reception of forward channel signals and the transmission of reverse channel signals by the RF transceiver 310, the RX processing circuitry 325, and the TX processing circuitry 315 in accordance with well-known principles. In some embodiments, the main processor 340 includes at least one microprocessor or microcontroller.

The main processor 340 is also capable of executing other processes and programs resident in the memory 360, such as operations for conducting dual quantization-domain decoding for low density parity check codes. The main processor 340 can move data into or out of the memory 360 as required by an executing process. In some embodiments, the main processor 340 is configured to execute the applications 362 based on the OS program 361 or in response to signals received from eNBs or an operator. The main processor 340 is also coupled to the I/O interface 345, which provides the UE 116 with the ability to connect to other devices such as laptop computers and handheld computers. The I/O interface 345 is the communication path between these accessories and the main controller 340.

The main processor 340 is also coupled to the keypad 350 and the display unit 355. The operator of the UE 116 can use the keypad 350 to enter data into the UE 116. The display 355 can be a liquid crystal display or other display capable of rendering text and/or at least limited graphics, such as from web sites.

The memory 360 is coupled to the main processor 340. Part of the memory 360 could include a random access memory (RAM), and another part of the memory 360 could include a Flash memory or other read-only memory (ROM).

Although FIGURE 3 illustrates one example ofUE 116, various changes can be made to FIGURE 3. For example, various components in FIGURE 3 could be combined, further subdivided, or omitted and additional components could be added according to particular needs. As a particular example, the main processor 340 could be divided into multiple processors, such as one or more central processing units (CPUs) and one or more graphics processing units (GPUs). Also, while FIGURE 3 illustrates the UE 116 configured as a mobile telephone or smartphone, UEs could be configured to operate as other types of mobile or stationary devices.

LDPC codes are linear codes that can be characterized by sparse parity check matrices H. The H-matrix has a low density of one's (1's). The sparseness of H yields a large $d_{min}$ and reduces decoding complexity. An exemplary H-matrix is represented by Equation 1:

$$H = \begin{bmatrix} 1 & 1 & 1 & 1 & 0 & 1 & 0 & 1 & 0 & 1 \\ 1 & 0 & 1 & 1 & 0 & 0 & 1 & 1 & 1 & 1 \\ 0 & 1 & 0 & 1 & 0 & 0 & 0 & 1 & 0 & 0 \\ 1 & 0 & 0 & 0 & 1 & 0 & 1 & 1 & 1 & 1 \\ 0 & 0 & 1 & 1 & 1 & 0 & 1 & 0 & 1 & 0 \end{bmatrix}. \quad (1)$$

An LDPC code is regular if: every row has the same weight, $W_r$; and every column has the same weight, $W_c$. The regular LDPC code is denoted by $(W_c, W_r)$-regular. Otherwise, the LDPC code is irregular. Regular codes are easier to implement and analyze. Further, regular codes have lower error floors. However, irregular codes can get closer to capacity than regular codes.

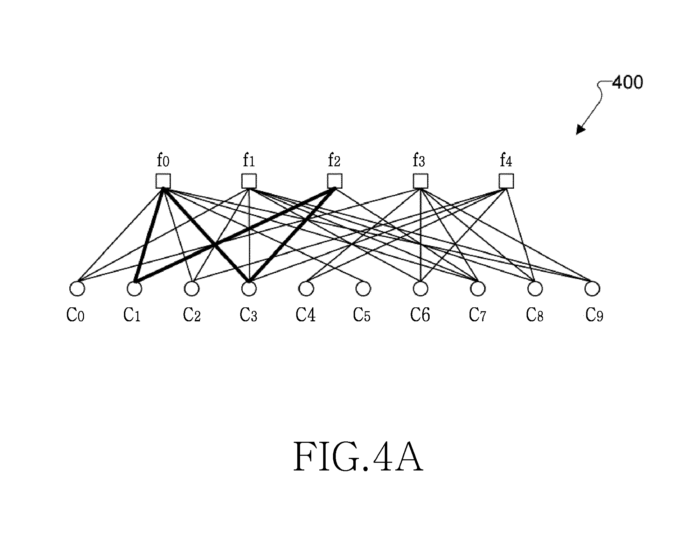

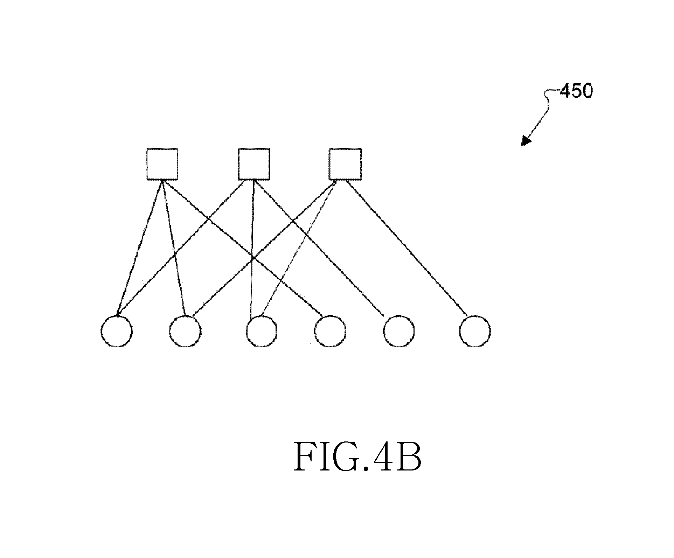

FIGURE 4A illustrates an example LDPC code Tanner graph according to this disclosure. FIGURE 4B illustrates another LDPC code Tanner graph according to this disclosure. The embodiments of the Tanner graph 400 and Tanner graph 450 shown in FIGURES 4A and 4B are for illustration only. Other embodiments of the Tanner graph 400 could be used without departing from the scope of this disclosure.

The Tanner graph 400 is a bipartite graph. In bipartite graphs, nodes are separated into two distinctive sets and edges are only connecting nodes of two different types. The two types of nodes in the Tanner graph 400 are referred to as Variable Nodes (VN) and Check Nodes (CN)

V-nodes correspond to bits of the codeword or, equivalently, to columns of the parity check H-matrix. There are $n$ VNs. The VN are also referenced as "bit nodes". The CN correspond to parity check equations or, equivalently, to rows of the parity check H-matrix. There are at least $m=n-k$ CNs.

The Tanner graph 400 corresponds to the parity check H-matrix illustrated by Equation 1. Additionally, the Tanner graph 450 corresponds to the parity check H-matrix illustrated by Equation 2.

$$H = \begin{bmatrix} 1 & 1 & 0 & 1 & 0 & 0 \\ 1 & 0 & 1 & 0 & 1 & 0 \\ 0 & 1 & 1 & 0 & 0 & 1 \end{bmatrix} \quad (2)$$

The Tanner graph 400 includes five (5) CNs corresponding to the number of parity bits and ten (10) VNs representing the number of bits in a codeword. The CN $f_i$ is connected to VN $c_j$ if the element $h_{ij}$ of H-matrix is a one (1). For example, CN $f_0$ is connected $c_0$, $c_1$, $c_2$, $c_3$, $c_5$, $c_7$ and $c_9$. The connection between $f_0$ and $c_0$ corresponds to $h_{00}$; the connection between $f_0$ and $c_2$ corresponds to $h_{01}$; and so forth. Therefore, the connections to $f_0$ correspond to the first row in the H-matrix, further illustrated in Equation 2:

$$\vec{H}_0 = \begin{bmatrix} 1 & 1 & 1 & 1 & 0 & 1 & 0 & 1 & 0 & 1 \end{bmatrix}. \quad (3)$$

A degree of a node is the number of edges (e.g., connections) connected to the node. A cycle is a total length, in the Tanner graph 400, of a path of distinct edges that closes upon itself. A path from $c_1 \rightarrow f_2 \rightarrow c_2 \rightarrow f_0 \rightarrow c_1$ is an example of a short cycle. Short cycles should be avoided since short cycles adversely affect decoding performance. Short cycles manifest themselves in the H-matrix by columns with an overlap two (2).

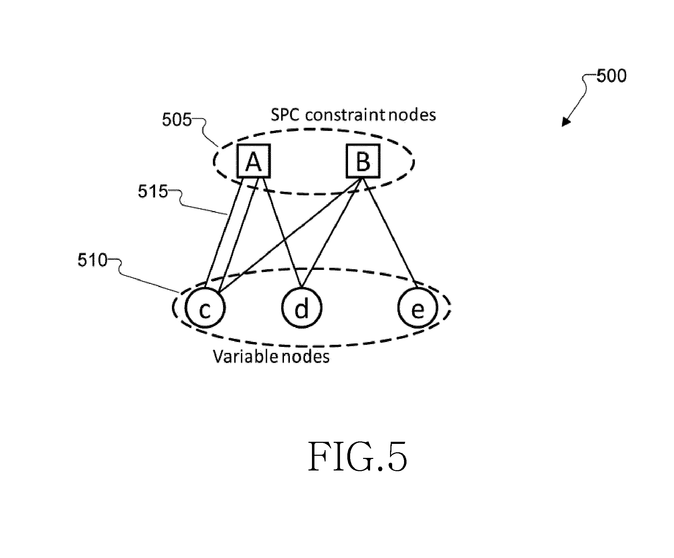

Theoretically, no constraints exist on the locations of the 1's in a low density parity check (LDPC) code's parity check matrix allowing the locations of the 1's to be very random. However, for practical considerations, it is preferable to have some structure in the locations of these 1's. Consequently, a class of LDPC codes called protograph-based LDPC codes (see REF 6) appeared in the industry. A protograph 500 (see REF 6 and REF 7) is a relatively small Tanner graph, such as illustrated in FIGURE 5, from which a larger graph can be obtained by the following copy-and-permute procedure.

The protograph 500 includes CNs 505 and VNs 510. Each edge 515 in the protograph is assigned a different "type." The protograph 500 is copied Z times, after which, the edges of the same type among the replicas are permuted and reconnected to obtain a single, large graph. Parallel edges are allowed in the protograph, but not in the derived graph. Note that the copy-and-permute procedure described in the definition can be simply represented by replacing each node in the protograph with a vector of nodes of the same type and replacing each edge in the protograph with a bundle of (permuted) edges of the same type.

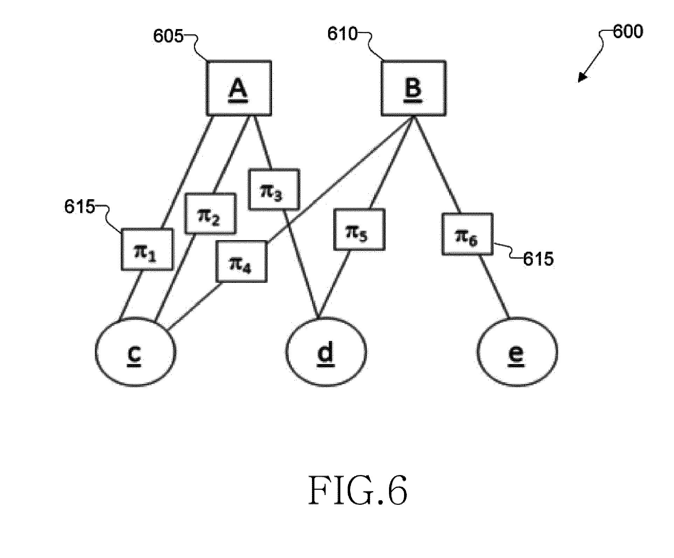

In the example shown in FIGURE 5, the protograph 500 consists of two CN-types (A, and B) and three VN-types (c, d, and e). An obtained "vectorized" protograph 600, which represents the derived LDPC code, is shown in FIGURE 6, where $\underline{A}$ 605 represents Z CNs of type A and $\underline{B}$ 610 represents Z CNs of type B and similarly for the VNs. The boxes $\pi_e$ 615 along each Z-edge in FIGURE 6 represent a permutation or adjacency matrix.

A protograph can also be described in a matrix form in the same way as writing the H matrix for a Tanner graph. However, the non-zero entries in the matrix take values equal to the number of parallel edges connecting two neighboring nodes. For example, the protograph 500 matrix is denoted by $H_p$ as shown Equation 3.

$$H_p = \begin{array}{c} \\ A \\ B \end{array} \begin{array}{ccc} c & d & e \\ \begin{bmatrix} 2 & 1 & 0 \\ 1 & 1 & 1 \end{bmatrix} \end{array} \tag{4}$$

The sum of the elements in any column is called column weight, *Wc.* Additionally, the sum of the elements in any row is called row weight, *Wr.*

For an attractive structured LDPC code, the protograph permutations should be in a circulant block form. That is, the permutation has the form $\pi_e = I^{(s)}$, where $I^{(s)}$ is the matrix resulting after $s$ right cyclic-shifts of the identity matrix.

For example:

$$I^{(0)} = \begin{bmatrix} 1 & 0 & 0 \\ 0 & 1 & 0 \\ 0 & 0 & 1 \end{bmatrix} \quad I^{(1)} = \begin{bmatrix} 0 & 1 & 0 \\ 0 & 0 & 1 \\ 1 & 0 & 0 \end{bmatrix} \quad I^{(2)} = \begin{bmatrix} 0 & 0 & 1 \\ 1 & 0 & 0 \\ 0 & 1 & 0 \end{bmatrix}$$

Consequently, the derived LDPC code's H matrix can be written in term of these circulant permutations as follows: First, replace every '0' in the protograph matrix $H_p$ by the $Z{\times}Z$ all-zeroes matrix. Second, replace every '1' in $H_p$ by one of the Z different $I^{(s)}$. Third, replace an element in $H_p$ with value $x$ (>1) by the sum of $x$ different $I^{(s)}$'s under the condition that no element in the resultant matrix is greater than one. For example, the construction of the LDPC H matrix of vectorized protograph 600 in FIGURE 6 has the general form shown in Equation 5:

$$H_{base} = \begin{bmatrix} \pi_1 + \pi_2 & \pi_3 & 0 \\ \pi_4 & \pi_5 & \pi_6 \end{bmatrix} \tag{5}$$

A specific example which uses circulant blocks and Z = 3 to construct H is shown in Equation 6:

$$H_{base} = \begin{bmatrix} I^{(0)} + I^{(1)} & I^{(0)} & 0 \\ I^{(0)} & I^{(1)} & I^{(2)} \end{bmatrix} \tag{6}$$

In one or more embodiments of this disclosure, $s$ can be used instead of $I^{(s)}$ and -1 is used to indicate the $Z{\times}Z$

all-zeroes matrix. Accordingly, the matrix above (called $H_{base}$ to recognize the description format) looks like:

$$H_{base} = \begin{bmatrix} 0+1 & 0 & -1 \\ 0 & 1 & 2 \end{bmatrix} \qquad (7)$$

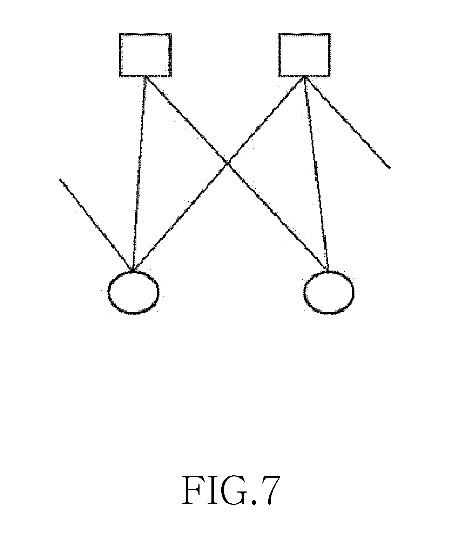

Another attractive property of protograph-based codes is that their performance can be predicted from the protograph. Note that the code rate of the derived graph is the same as that computed from the protograph, the code length is equal to the number of VNs in the protograph times Z, and more important the minimum signal-to-noise ratio (SNR) required for successful decoding (called protograph threshold) can be computed for the protograph using protograph EXIT analysis (see Ref. 8). The protograph threshold serves as a good indicator on the performance of the derived LDPC code. Note that the threshold SNR is achievable if the derived graph is cycle-free. Here, a cycle is a closed path in the graph, which starts at a given node and return to the same node. The number of edges in this closed path is called the size of the cycle. For example, FIGURE 7 is an example of a cycle with size 4. For this reason, which also is related to the iterative decoding performance, it is desirable to maximize the size of the smallest cycle in the LDPC code's graph. In general, progressive edge growth (PEG) algorithm (see REF 9) is used to select the suitable circulant permutations to maximize the size of the smallest cycles in the LDPC code's graph. In REF 10, several LDPC codes with lengths 432 and 1728 were proposed, and with the following rates: rate-3/8, rate-1/2, rate-5/8, rate-3/4, and rate-13/16. In Ref. 11, layered decoder architectures were presented that lower a power consumption of the LDPC decoder.

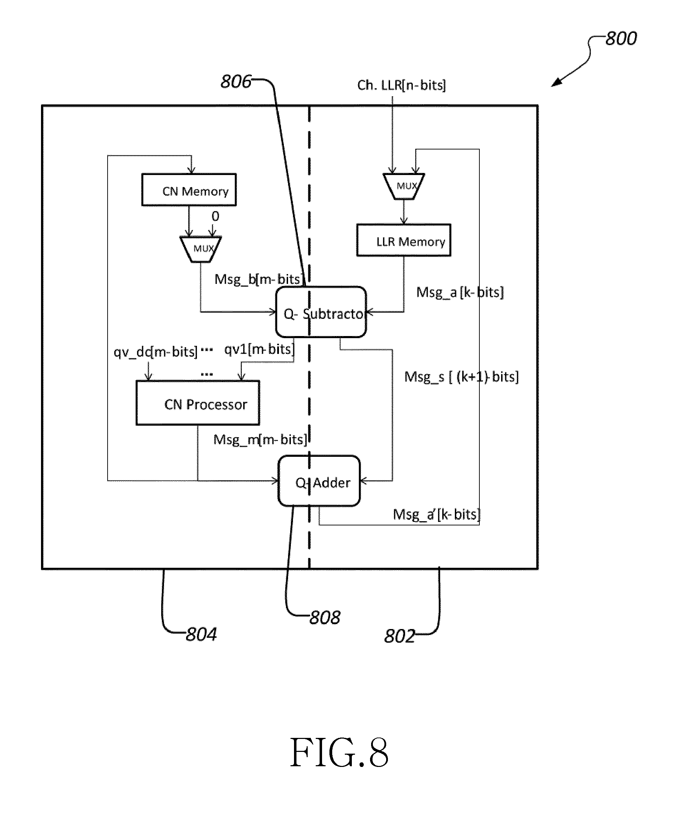

FIGURE 8 illustrates an example dual quantization-domains layered LDPC decoder 800 according to this disclosure. The embodiment of the dual quantization-domains layered LDPC decoder 800 shown in FIGURE 8 is for illustration only. Other embodiments of the dual quantization-domains layered LDPC decoder 800 could be used without departing from the scope of this disclosure.

The dual quantization-domains layered LDPC decoder 800 includes two quantization domains. A first quantization domain is the variable-node (VN) domain 802, which has high bit-resolution (k-bits in the example shown in FIGURE 8). This allows for larger dynamic range for VN's messages, which enables better tracking of the bits' mutual information, and also improves the probability of decoding success. A second quantization domain is the check-node (CN) domain 804, which has low-bit resolution (m-bits in the figure). This leads to low routing requirements between VN 802 and CN 804, and reduces the complexity of the CN 804. Routing problems and the CN 804 complexity in binary LDPC decoder dominate the complexity.

In certain embodiments, two functions are defined. A first function, denoted by $Q$, maps the message value from the high-resolution domain to the low-resolution domain. A second function, denoted by $Qinv$, maps the message value from the low-resolution domain to the high-resolution domain.

The dual quantization-domains layered LDPC decoder 800 includes a subtraction operation (Q-Substractor 806) that has two inputs and two outputs, where Input 1 is k-bits (high resolution), Input 2 is m-bits (low-resolution), Output 1 is k-bits, and Output 2 is m-bits.

$$\text{Output } 1 = \text{Input } 1 - Qinv(\text{Input } 2),$$

$$\text{Output } 2 = Q(\text{Output } 1),$$

Where, the subtraction is a regular binary subtraction.

The dual quantization-domains layered LDPC decoder 800 includes an addition operation (Q-Adder 808) that has two inputs and one output, where Input 1 is(k+1)-bits (high resolution), Input 2 is m-bits (low-resolution), and Output 1 is k-bits.

$$\text{Output } 1 = \text{Input } 1 + Qinv(\text{Input } 2),$$

Where the addition is a regular binary addition.

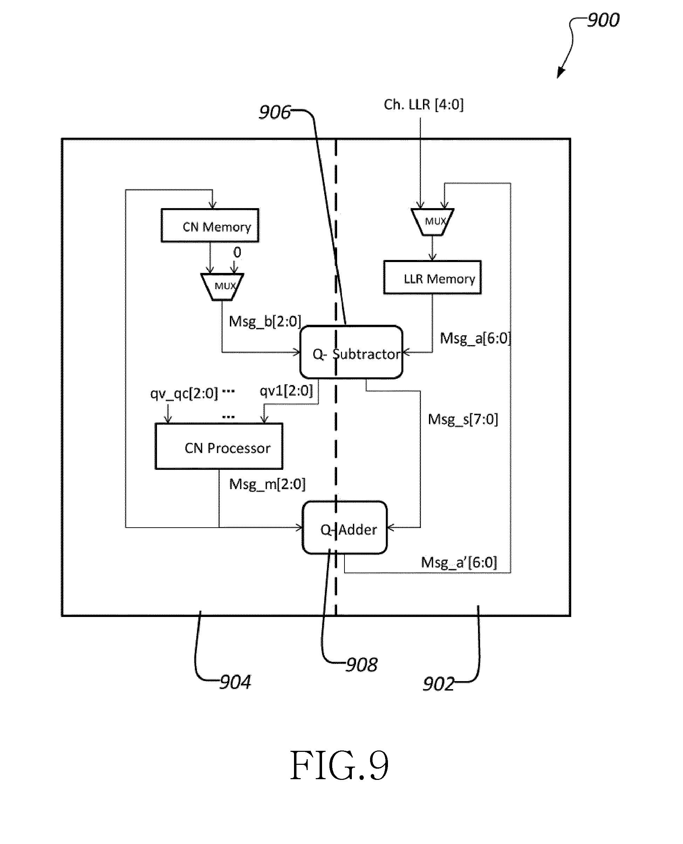

FIGURE 9 illustrates an example dual quantization-domains layered LDPC decoder 900 according to this disclosure. The embodiment of the dual quantization-domains layered LDPC decoder 900 shown in FIGURE 9 is for illustration only. Other embodiments of the dual quantization-domains layered LDPC decoder 900 could be used without departing from the scope of this disclosure.

The dual quantization-domains layered LDPC decoder 900 includes two quantization domains. A first quantization domain is the variable-node (VN) domain 902 that has high bit-resolution of 7-bits. This allows for larger dynamic range for the VN's messages, which further enables better tracking of the bits' mutual information, and also improves the probability of decoding success. A second quantization domain is the check-node (CN) domain 904 that has low-bit resolution of 3-bits. This leads to low routing requirements between VN 902 and CN 904, and reduces the complexity of the CN 904. Routing problems and the CN 904 complexity in binary LDPC decoder dominate the complexity.

In certain embodiments, two functions are defined. A first function denoted by $Q$ maps the message value from the high-resolution domain to the low-resolution domain. A second function denoted by $Qinv$ maps the message value from the low-resolution domain to the high-resolution domain. In this embodiment:

$$Q(x) = \begin{cases} 011 & ,0001000 \leq x \\ 010 & ,0000100 \leq x < 0001000 \\ 001 & ,0000010 \leq x < 0000100 \\ 000 & ,1111110 < x < 0000010 \\ 101 & ,1111100 < x \leq 1111110 \\ 110 & ,1111000 < x \leq 1111100 \\ 111 & ,x \leq 1111000 \end{cases}$$

$$Qinv(b) = \begin{cases} 0001011 & ,b = 011 \\ 0000100 & ,b = 010 \\ 0000010 & ,b = 001 \\ 0000000 & ,b = 000 \\ 1111110 & ,b = 101 \\ 1111100 & ,b = 110 \\ 1110101 & ,b = 111 \end{cases}$$

Where the operations in the 7-bits domain are the same as binary operations in two's complement format.

The dual quantization-domains layered LDPC decoder 900 includes a subtraction operation (Q-Substractor 906) and an addition operation (Q-Adder 908).

In certain embodiments, a decoding algorithm for a dual quantization-domains layered LDPC decoding includes the following:

Initialization: For k=0, the check-to-variable messages are initialized to zero.

Furthermore, $L_j^{ps,0}(0) = L_j^{pr}$ , for $1 \leq j \leq$ N, where $L_j^{ps,l}(k)$ denotes the posterior LLR value corresponding to the $j$th VN at time $k$ and subiteration $l$, and $L_j^{pr}$ denotes the quantized log-likelihood ratios for the $j$th VN received from the channel.

At iteration $k$ and layer $l$:

Each check node at the $l$th layer receives the following messages from its VN neighbors:

$$Msg_{v_j \to c_i^l}(k) = Q(L_j^{ps,l-1}(k) - Qinv(Msg_{c_i^l \to v_j}(k-1)))$$

For $j \in \mathbf{N}_{c_i^l}$ and 1≤l≤M. Note, $L_j^{ps,0}(k) = L_j^{ps,l}(k-1)$ .

Each check node will then send the following value to its VN neighbors:

$$Msg_{c_i^l \to v_j}(k) = \begin{cases} \varepsilon_{c_i^l,v_j}(k) \, | \, Msg_{v_{m_i^l(k)} \to c_i^l}(k) |, j \neq m_i^l(k) \\ \varepsilon_{c_i^l,v_j}(k) \, | \, Msg_{v_{n_i^l(k)} \to c_i^l}(k) |, j = m_i^l(k) \end{cases}$$

Where $m_i^l(k) = \arg\min_{q \in N_{c_i^l}} | Msg_{v_q \to c_i^l}(k) |,$

$$n_i^l(k) = \arg\min_{q \in N_{c_i^l} \setminus m_i^l(k)} | Msg_{v_q \to c_i^l}(k) |, \quad \varepsilon_{c_i,v_j}(k) = \prod_{q \in N_{c_i} \setminus \{j\}} sgn(Msg_{v_q \to c_i}(k)),$$

|x| is the magnitude of x, and sgn(x) is the sign of x.

The posterior LLR value is updated as:

$$L_j^{ps,l}(k) = L_j^{ps,l-1}(k) - Qinv(Msg_{c_i^l \to v_j}(k-1)) + Qinv(Msg_{c_i^l \to v_j}(k))$$

<u>Decision:</u> Hard decision are then made based on the sign of the posterior LLR values, $L_j^{ps,l}(k)$ .

In certain alternative embodiments, the bit resolution of the VN domain, k-bits, is computed as k = ceil(log2 (max{|Qinv(b)|} * max{VN degree} + 2^(n-1))+1. This condition ensures that no overflow occurs in the decoder circuits so that no need exists for saturation circuits and message freezing circuits.

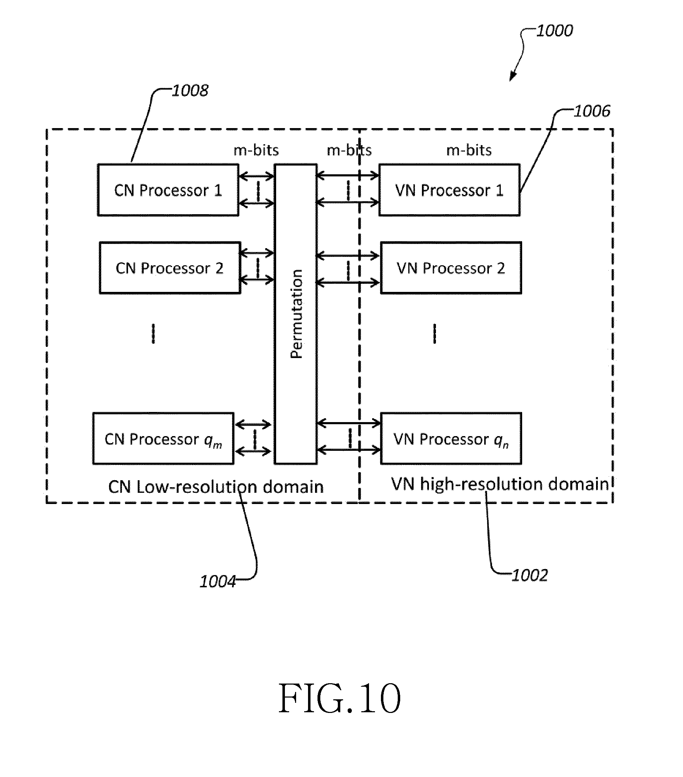

FIGURE 10 illustrates an example dual quantization-domains flooding LDPC decoder 1000 according to this disclosure. The embodiment of the dual quantization-domains flooding LDPC decoder 1000 shown in FIGURE 10 is for illustration only. Other embodiments of the dual quantization-domains flooding LDPC decoder 1000 could be used without departing from the scope of this disclosure.

The dual quantization-domains flooding LDPC decoder 1000 includes variable-node (VN) domain 1002 that has high bit-resolution and a check-node (CN) domain 1004, which has low-bit resolution. In this embodiment, the dual quantization-domains flooding LDPC decoder 1000 includes multiple VN processors 1006 and multiple CN processors 1008. In certain embodiments, the VN architecture is substantially similar to the VN architecture 900 shown in FIGURE 9.

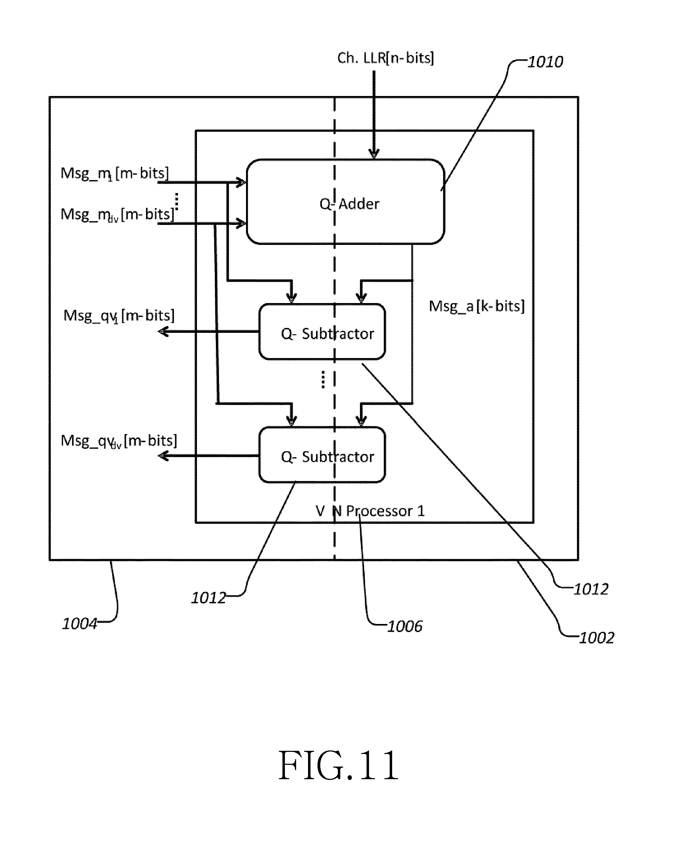

FIGURE 11 illustrates an example VN processor 1006 according to this disclosure. The embodiment of the VN processor 1006 shown in FIGURE 11 is for illustration only. Other embodiments of the VN processor 1006 could be used without departing from the scope of this disclosure. In the examples shown in FIGURE 11, the VN processor 1006 includes a Q-Adder 1010 and a plurality of Q-Subtractors 1012.

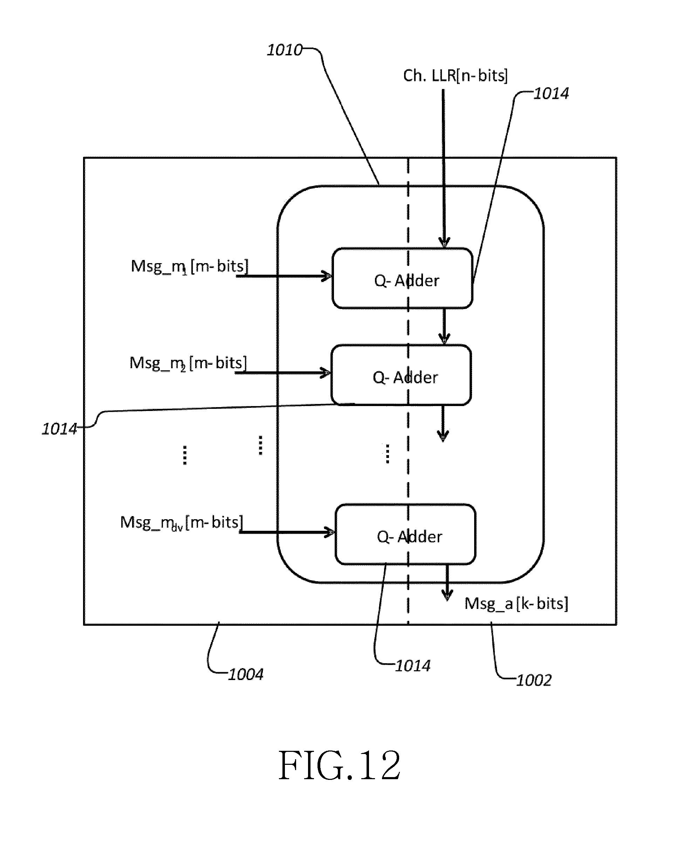

FIGURE 12 illustrates an example Q-Adder 1010 according to this disclosure. The embodiment of the Q-Adder 1010 shown in FIGURE 12 is for illustration only. Other embodiments of the Q-Adder 1010 could be used without departing from the scope of this disclosure. In the example shown in FIGURE 12, the Q-Adder 1010 includes a plurality of cascaded Q-Adders 1014. In certain embodiments, on or more of the Q-Adders and Q-Subtractors of dual quantization-domains flooding LDPC decoder can be implemented as a truth table or look-up table (LUT) stored on a memory unit (e.g., ROM).

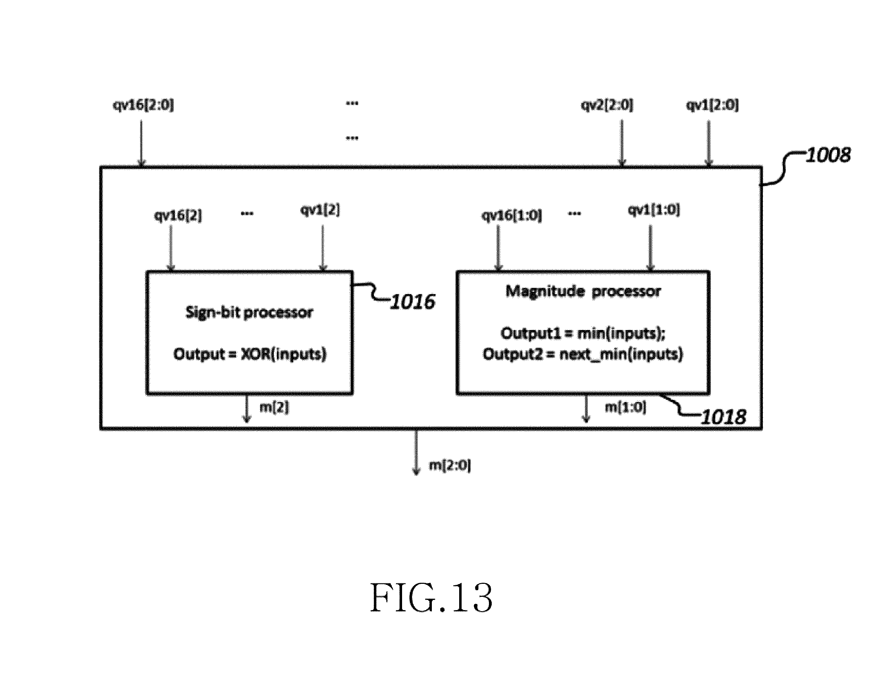

FIGURE 13 illustrates an example CN processor 1008 according to this disclosure. The embodiment of the CN processor 1008 shown in FIGURE 13 is for illustration only. Other embodiments of the CN processor 1008 could be used without departing from the scope of this disclosure. In the example shown in FIGURE 13, the CN processor 1008 includes a sign-bit processor 1016 and a magnitude processor 1018.

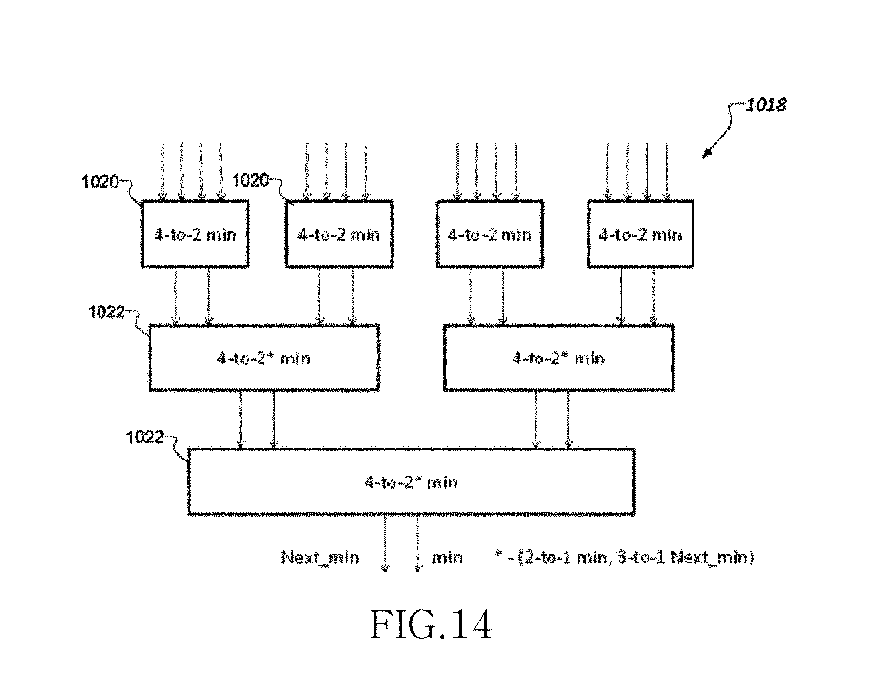

FIGURE 14 illustrates an example magnitude processor 1018 according to this disclosure. The embodiment of the magnitude processor 1018 shown in FIGURE 14 is for illustration only. Other embodiments of the magnitude processor 1018 could be used without departing from the scope of this disclosure. The magnitude processor 1018 is constructed using several 4-to-2 min processors 1020, where each 4-to-2 min processor 1020 takes 4 unsigned inputs in parallel and outputs the smallest input as the min and the second smallest as the next_min as below (assuming all inputs are absolute):

$$\mathrm{Out\_Min} = \min(\mathrm{In\_Min\_1}, \mathrm{In\_Min\_2}, \mathrm{In\_Min\_3}, \mathrm{In\_Min\_4}) = \min(\min(\mathrm{In\_Min\_1},$$
$$\mathrm{In\_Min\_2}), \min(\mathrm{In\_Min\_3}, \mathrm{In\_Min\_4}))$$

$$\mathrm{Out\_Next\_Min} = \min(\max(\mathrm{In\_Min\_1}, \mathrm{In\_Min\_2}), \max(\mathrm{In\_Min\_3}, \mathrm{In\_Min\_4}),$$
$$\max(\min(\mathrm{In\_Min\_1}, \mathrm{In\_Min\_2}), \min(\mathrm{In\_Min\_3}, \mathrm{In\_Min\_4})))$$

The 4-to-2 min processor 1020 can be implemented using comparators. Alternatively, when the inputs have low resolution (e.g., 2-bits), the 4-to-2 min processor 1020 can be implemented as a truth table or look-up table (LUT) stored in a memory (e.g., ROM). Alternatively, the 4-to-2 min processor 1020 can be implemented as a combinatorial logic. The 4-to-2* min detector 1022 used for the second and beyond stages is a simplified version of the 4-to-2 min detector used in the first stage, since the input to these min detectors is already pre-determined for min and next-min values. Accordingly, the output for the 4-to-2* min detectors 1022 is (assuming all inputs are absolute):

$$\mathrm{Out\_Min} = \min(\mathrm{In\_Min\_1}, \mathrm{In\_Min\_2})$$

$$\mathrm{Out\_Next\_Min} = \min(\mathrm{In\_Next\_Min\_1}, \mathrm{In\_Next\_Min\_2}, \max(\mathrm{In\_Min\_1},$$
$$\mathrm{In\_Min\_2}))$$

In certain embodiments, instead of finding the Next_Min in the CN processor 1008, an approximation of the next_min can be used. In certain embodiments, the min can be used as as the Next_Min. In certain embodiments, an approximation can be to use the Next_Min = 01, 10, 11 for the min values 00, 01, (10, or 11), respectively.

As compared to single quantization domain LDPC systems, the dual quantization-domains LDPC decoders disclosed herein can be provided without a scaling module, a saturation module, or a posterior LLR freezing module. Routing messages between the VNs and the CNs scales linearly with the message bit-precision. More routes, implies more processor or chip area, which results in larger power consumption. Reducing the bit precision for the messages between the VN and the CN requires less routing between the VN and the CN (e.g., from 7-bits to 3-bits requires 57% less routing), which translate into power reduction. Similarly, the complexity and operating maximum frequency for the adders and comparators scales with message bit-precision.

In an alternative embodiment, an LDPC code is defined by a sparse $M \times N$ parity check matrix H, where $M$ represents the number of parity checks and $N$ represents the number of bits in the codeword. Graphically, the H matrix of an LDPC code is represented by a Tanner graph which consists of $M$ CNs and $N$ VNs. A quasi-cyclic (QC) LDPC code is a structured LDPC code in which H consists of $M_p \times N_p$ sub-matrices, where each sub-matrix is either a $Z \times Z$ cyclic permutation matrix (i.e., cyclically shifted identity matrix) or a $Z \times Z$ all-zeros matrix. Many of the LDPC codes used in standards (IEEE 802.16m, IEEE 802.11n, and IEEE 802.11ad) are QC-LDPC codes. In a layered scheduling, the QC-LDPC H matrix is divided into $M_p$ layers, where each layer consists of the $Z$ CNs in a row of the sub-matrices of H. Accordingly, each iteration is divided into $M_p$ sub-iterations. In a sub-iteration only the CNs in the corresponding layer update the posterior-log-likelihood-ratios of the VNs in their neighborhood.

Let $v_j$ refers to the $j^{th}$ VN, where $1 \le j \le N$, and let $c_{i,l}$ refers to the $i^h$ CN in the $l^{th}$ layer, where $1 \le i \le Z$, and $1 \le l \le M_p$. Note that $Z \cdot M_p = M$. Also, let $_{ci,l}$ denotes the set of indices to the VNs in the neighborhood of $c_{i,l}$. Also let $L_j^{pr}$ refers to the channel LLR value associated with $v_j$.

$$L_j^{pr} = \log\left(\frac{\Pr\{\hat{v}_j=0|y_j\}}{\Pr\{\hat{v}_j=1|y_j\}}\right), \qquad (8)$$

where, $\hat{v}_j$ is the codeword's bit associated with $v_j$, and $y_j$ is the received signal. Example, in the case of a BPSK modulation over AWGN channel: $y_j = (-1)^{\hat{v}_j} + n$, where $n$ is an additive Gaussian noise with zero mean and variance $\sigma_n^2$, and $L_j^{pr} = (2/\sigma_n^2)y_j$. Also, let $L_j^{ps,l}(k)$ denote the posterior LLR value corresponding to $v_j$, which is calculated at the $l^{th}$ sub-iteration of the $k^{th}$ iteration. Note, the output of the last sub-iteration in the $(k-1)^{th}$ iteration is the input to the first sub-iteration in iteration $k^{th}$ iteration, and so $L_j^{ps,0}(k) = L_j^{ps,M_p}(k-1)$, for $k \geq 2$. Moreover, let $\Psi_{v_j \to c_{i,l}}(k)$ refers to the message sent form $v_j$ to $c_{i,l}$ at the $k^{th}$ iteration, and let $\Psi_{c_{i,l} \to v_j}(k)$ refers to the message sent form $c_{i,l}$ to $c_j$ at the $k^{th}$ iteration.

In our proposed DQD decoder, the VNs operate in a high-precision (e.g., 7-bits) quantization domain, and the CNs operate in a low-precision (3-bits) quantization domain. For mapping the messages from the high-precision quantization domain to the low-precision quantization domain, the following non-injective map is defined:

$$Q(x) = \begin{cases} 3 & , \quad t_3 \leq x \\ 2 & , \quad t_2 \leq x < t_3 \\ 1 & , \quad t_1 \leq x < t_2 \\ 0 & , -t_1 < x < t_1 \\ -1 & , -t_2 < x \leq -t_1 \\ -2 & , -t_3 < x \leq -t_2 \\ -3 & , \qquad x \leq -t_3 \end{cases},$$

where $t_1$, $t_2$, and $t_3$ are elements in the high-precision quantization domain, which satisfy $0 < t_1 < t_2 < t_3$. Alternatively, for mapping the messages from the low-precision quantization domain to the high precision quantization domain, the following non-surjective map is defined:

$$\bar{Q}(x) = \begin{cases} d_3 & ,x = 3 \\ d_2 & ,x = 2 \\ d_1 & ,x = 1 \\ 0 & ,x = 0 \\ -d_1 & ,x = -1 \\ -d_2 & ,x = -2 \\ -d_3 & ,x = -3 \end{cases},$$

where $d_1$, $d_2$, and $d_3$ are elements in the high-precision quantization domain, which satisfy $0 < d_1 < d_2 < d_3$. Note that the mapping between the two quantization domains is completely defined by the elements $t_1$, $t_2$, $t_3$, $d_1$, $d_2$, and $d_3$. And so, the notation DQD$\{t_1, t_2, t_3; d_1, d_2, d_3\}$ is used to indicate which mappings are used in the DQD LDPC decoder.

The proposed DQD decoding algorithm is as follows:

- Initialization:

  ∘ Set $\Psi_{c_{i,l} \to v_j}(0) = 0$ for $1 \leq i \leq Z$, $1 \leq l \leq M_p$, and $j \in \mathbb{N}_{c_{i,l}}$.

  ∘ Set $L_j^{ps,0}(0) = L_j^{pr}$, for $1 \leq j \leq N$.

  ∘ $S = 0$;

- At sub-iteration $l$ of the $k^{th}$ iteration:

  o VN update: For each $c_{i,l}$, $1 \le i \le Z$, and each $v_j$, $j \in \mathbb{N}_{c_{i,l}}$ compute:

$$\Psi_{v_j \to c_{i,l}}(k) = Q(L_j^{ps,l-1}(k) - \bar{Q}(\Psi_{c_{i,l} \to v_j}(k-1)).$$

  o CN update: For each $c_{i,l}$, $1 \le i \le Z$, and each $v_j$, $j \in \mathbb{N}_{c_{i,l}}$ compute:

$$\Psi_{c_{i,l} \to v_j}(k) = \begin{cases} \varepsilon_{c_{i,l},v_j}(k) \cdot |\Psi_{v_{m_{i,l}(k)} \to c_{i,l}}(k)| & , j \neq m_{i,l}(k) \\ \varepsilon_{c_{i,l},v_j}(k) \cdot |\Psi_{v_{n_{i,l}(k)} \to c_{i,l}}(k)| & , j = m_{i,l}(k) \end{cases},$$

Where

$$m_{i,l}(k) = \arg\min_{q \in \mathbb{N}_{c_{i,l}}} |\Psi_{v_q \to c_{i,l}}(k)|,$$

$$n_{i,l}(k) = \arg\min_{q \in \mathbb{N}_{c_{i,l}} \setminus m_{i,l}(k)} |\Psi_{v_q \to c_{i,l}}(k)|,$$

$$\varepsilon_{c_{i,l},v_j}(k) = \prod_{q \in \mathbb{N}_{c_{i,l}} \setminus j} \text{sgn}(\Psi_{v_q \to c_{i,l}}(k)),$$

and |x| is the magnitude of $x$, and sgn($x$) is the sign of $x$.

  o Early stopping rule: For each $c_{i,l}$, $1 \le i \le Z$, and each $v_j$, $j \in \mathbb{N}_{c_{i,l}}$ compute:

$$\chi_{v_j \to c_{i,l}}(k) = \text{sgn}(L_j^{ps,l-1}(k)).$$

If $\prod_{q \in \mathbb{N}_{c_{i,l}}} \text{sgn}(\Psi_{v_q \to c_{i,l}}(k)) = +1$ for all $1 \le i \le Z$,

$$S = S+1;$$

Else,

$$S = 0;$$

If S = $M_p$ or maximum number of iterations reached,
Break and go to Decision.
Else,
Continue.

  o VN posterior LLR values update:

$$L_j^{ps,l}(k) = L_j^{ps,l-1}(k) - \bar{Q}\left(\Psi_{c_{i,l} \to v_j}(k-1)\right) + \bar{Q}(\Psi_{c_{i,l} \to v_j}(k))$$

• <u>Decision:</u> Hard decisions are then made based on the sign of the posterior LLR values $L_j^{ps,l}(k)$.

$\Psi_{v_j \to c_{i,l}}(k)$ and $\Psi_{c_{i,l} \to v_j}(k)$ are in the set {-3, -2, -1, 0, 1, 2, 3}. However, $L_j^{ps,l}(k)$ can grow up to $d_3$ times the degree of $v_j$ plus the maximum possible value of $L_j^{pr}$. For example, if $d_3$ = 12, the maximum VN's degree is 4, and $L_j^{pr}$ is quantized using a 5-bits uniform quantization, then $L_j^{pr} \in \{-16, -15, ..., 14, 15\}$, and so $L_j^{ps,l}(k) \in \{-64, -63, ..., 62, 63\}$. Also, note that in the DQD decoding algorithm above, *if Q(x)and Q (x) are* redefined as Q(*x*) = *x,* and $\overline{Q}$(*x*) = *x*, then it will be identical to a layered Min-Sum decoding algorithm (without scaling). In the early stopping rule, only the CNs in the processed layer are checked. If all CNs in the layer are satisfied, the layer is considered valid. If $M_p$ consecutive layers are valid, the decoder will be stopped. This early stopping criterion is not the same as the syndrome check criterion.

In certain embodiments, the following mappings are utilized: DQD {1, 3, 6; 1, 3, 6} and DQD{2, 4, 8; 2, 4, 9} for the rate-1/2 LDPC code at SNR points 2.4 dB and 3.0 dB, respectively. DQD{1, 3, 6; 1, 3, 7} and DQD{1, 4, 8; 1, 4, 9} for the rate-13/16 LDPC code at SNR points 4.0 dB and 5.0 dB, respectively. In some cases, DQD{1, 3, 6; 1, 3, 6} for the low-SNR region and DQD{2, 4, 8; 2, 4, 9} for the high-SNR region can be utilized. Alternatively, a few iterations can use DQD{1, 3, 6; 1, 3, 6} before switching to DQD{2, 4, 8, 2, 4, 9}.

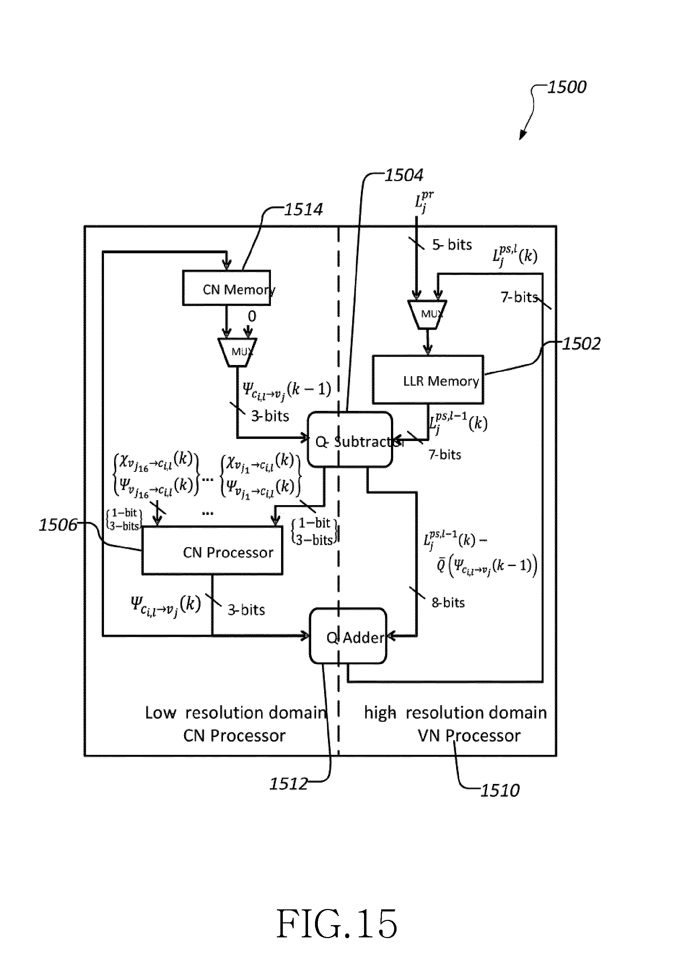

FIGURE 15 illustrates an example dual quantization-domains layered LDPC decoder 1500 according to this disclosure. The embodiment of the dual quantization-domains layered LDPC decoder 1500 shown in FIGURE 15 is for illustration only. Other embodiments of the dual quantization-domains layered LDPC decoder 1500 could be used without departing from the scope of this disclosure.

The main modules of the layered DQD LDPC 1500 decoder are shown in FIGURE 15. The 5-bits quantized channel LLR values, $L_j^{pr}$, are first saved in the LLR memory 1502. The LLR memory 1502 holds a 7-bits value for each VN in the LDPC code, and it gets updated every sub-iteration with the new posterior-LLR values. The Q-Subtractor 1504 takes two inputs, the last posterior-LLR value, $L_j^{ps,l-1}(k)$, and the CN message, $\Psi_{c_{i,l} \to v_j}(k$-1) 1), from the previous iteration, and generates three outputs. The first output is an 8-bit value $L_j^{ps,l-1}(k) - \bar{Q}(\Psi_{c_{i,l} \to v_j}(k-1))$. The second output is a 3-bit message to be sent to the CN processor 1506. In this message, the least two significant bits represent the non-linearly mapped magnitude of the message according to the function Q(x) and the most significant bit is the sign of the message. The sign bit is zero for non-negative values and one otherwise. The third output is the sign of $L_j^{ps,l-1}(k)$, which will be used in the early termination of the decoder. The first output stays in the VN processor 1510, while the other two are sent to the CN processor 1506. The output of the CN processor 1506 is sent to the Q-Adder 1512, and saved in the CN memory 1514 for use in the next iteration. The Q-Adder 1512 computes the new posterior-LLR by adding $\overline{Q}(\Psi_{c_{i,l} \to v_j}(k))$ to the 8-bit output of the Q-Subtractor 1504.

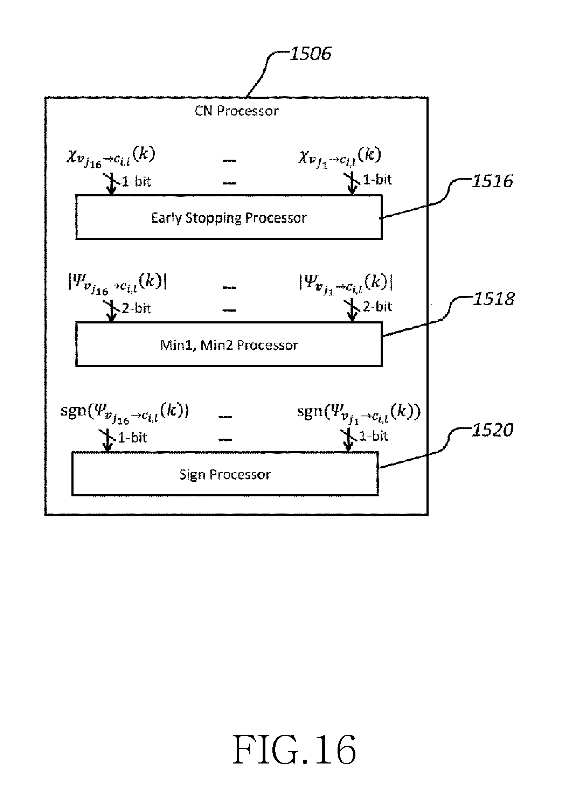

FIGURE 16 illustrates an example CN processor 1506 according to this disclosure. The embodiment of CN processor 1506 shown in FIGURE 16 is for illustration only. Other embodiments of the CN processor 1506 could be used without departing from the scope of this disclosure. The CN processor 1506 includes three modules: the Early Stopping processor 1516, the (Min1, Min2) processor 1518, and the Sign processor 1520.

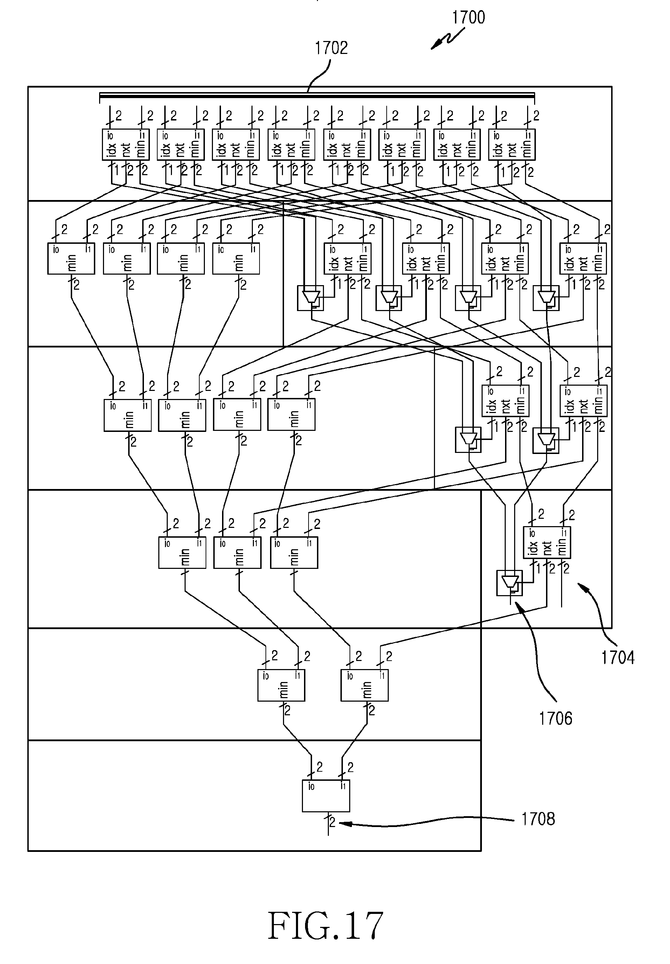

FIGURE 17 illustrates an example (Min1,Min2) processor architecture 1700 according to this disclosure. The embodiment of (Min1,Min2) processor architecture 1700 shown in FIGURE 17 is for illustration only. Other embodiments of the (Min1,Min2) processor architecture 1700 could be used without departing from the scope of this disclosure. The (Min1,Min2) processor architecture 1700 includes a sixteen value input 1702, a Min1 1704, a Min index 1706, and a Min2 1708. In the example shown in FIGURE 17 the (Min1,Min2) processor architecture 1700 is a portion of the CN processor 1506.

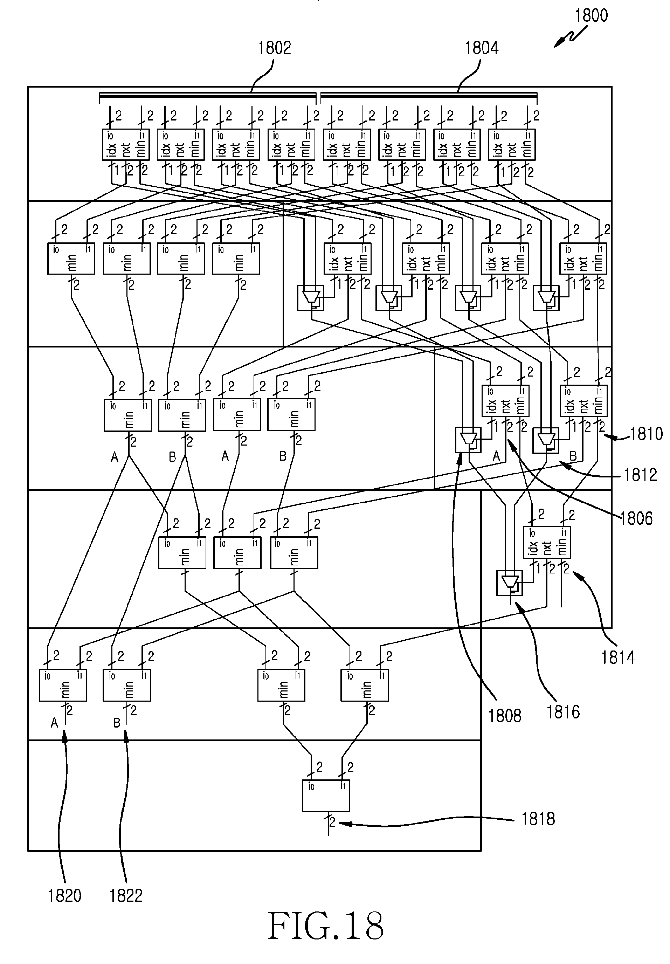

FIGURE 18 illustrates an example (Min1,Min2) processor architecture with programmable input 1800 according to this disclosure. The embodiment of the (Min1,Min2) processor architecture with programmable input 1800 shown in FIGURE 18 is for illustration only. Other embodiments of the (Min1,Min2) processor architecture with programmable input 1800 could be used without departing from the scope of this disclosure. The (Min1,Min2) processor architecture with programmable input 1800 includes an 8 value input A 1802, an 8 value input B 1804, a Min1 A 1806, a Min index A 1808, a Min1B 1810, a Min index B 1812, a Min1 1814, aMin index 1816, aMin 2 1818, aMin 2A 1820, and a Min 2B 1822. In this embodiment the (Min1,Min2) processor architecture with programmable input 1800 can be a portion of the CN processor 1506.

The dual quantization-domain (DQD) LDPC decoders disclosed herein are configured so that the channel log-likelihood-ratio (LLR) values and the LDPC variable nodes (VN) that operate in one quantization domain, and the LDPC check nodes (CN) operate in another quantization domain. A mapping is defined to transform the messages between the quantization domains. In certain embodiments where the disclosed LDPC decoding solutions are utilized by battery-powered wireless communication devices, LDPC decoding algorithms are disclosed with lower implementation complexity as compared to a scaled Min-Sum and without significant loss (<0.1dB) in performance around bit error rate (BER) of $10^{-6}$. Certain DQD decoding algorithms disclosed are designed to operate over the additive white Gaussian noise (AWGN) and fading channels. In certain embodiments, from hardware perspective, LDPC decoders with layered scheduling (or, layered LDPC decoders) converge faster than flooding LDPC decoders, and have smaller implementation area.

Although the present disclosure has been described with an exemplary embodiment, various changes and modifications may be suggested to one skilled in the art. It is intended that the present disclosure encompass such changes and modifications as fall within the scope of the appended claims.

**Claims**

1. A low density parity check (LDPC) decoder, comprising:

   a variable-node (VN) processing domain comprising high-bit resolution processing circuitry;
   a check-node (CN) processing domain comprising low-bit resolution processing circuitry lower than the high-bit resolution processing circuitry; and
   mapping circuitry configured to transfer a message between the VN processing domain and the CN processing domain.

2. The LDPC decoder of claim 1, wherein the mapping circuitry is configured to generate a first mapping for transferring the message from the VN processing domain to the CN processing domain.

3. The LDPC decoder of claim 2, wherein the mapping circuitry comprises a Q-Subtractor,
   wherein the Q-Subtractor is implemented as at least one of a look-up table stored on a memory unit and combinatorial logic gates.

4. The LDPC decoder of claim 1, wherein the mapping circuitry is configured to generate a second mapping for transferring the message from the CN processing domain to the VN processing domain.

5. The LDPC decoder of claim 4, wherein the mapping circuitry comprises a Q-Adder.
   wherein the Q-Adder is implemented as at least one of a look-up table stored on a memory unit and combinatorial logic gates.

6. The LDPC decoder of claim 1, wherein the high-bit resolution processing circuitry, the low-bit processing circuitry, and the mapping circuitry are configured to provide at least one of a layered scheduling and a flooding scheduling.

7. The LDPC decoder of claim 1, wherein the low-bit processing circuitry comprises an early stopping processor.

8. The LDPC decoder of claim 7, wherein the low-bit processing circuitry comprises:

   a sign-bit processor; and
   a magnitude processor.

9. The LDPC decoder of claim 8, wherein the magnitude processor comprises a plurality of 4-to-2 min processors.

10. The LDPC decoder of claim 8, wherein the magnitude processor comprises a plurality of 4-2 min processors in a first tier and a plurality of 4-to-2* min processors in a following tier.

**11.** The LDPC decoder of claim 8, wherein the magnitude processor comprises a Min1, Min2 processor, which comprises a plurality of 2-to-1 min processors,
wherein the Min1, Min2 processor comprises a programmable input comprising at least one of a sixteen value input and two eight value inputs.

**12.** The LDPC decoder of claim 1, wherein the VN processing domain is determined based on the low-bit resolution to high-bit resolution mapping, maximum VN degree, and bit resolution of a received log-likelihood-ratio message to avoid overflow.

**13.** A method of decoding low density parity check (LDPC) codes, comprising:

receiving high-bit resolution messages at a high-bit resolution variable-node (VN) processing domain;
applying VN processing in the VN processing domain;
mapping the high-bit resolution messages to low-bit resolution messages having a bit resolution lower than the bit resolution of the high-bit resolution messages;
applying check-node (CN) processing in a low-bit resolution CN processing domain;
mapping the low-bit resolution messages to high-bit resolution messages; and
applying multiple iterations between the VN processing and the CN processing.

**14.** The method of decoding LDPC codes of claim 13, wherein VN processing domain is determined based on the low-bit resolution to high-bit resolution mapping, maximum VN degree, and bit resolution of a received log-likelihood-ratio message to avoid overflow.

**15.** The method of decoding LDPC codes of claim 13, wherein mapping the high-bit resolution messages to low-bit resolution messages and mapping the low-bit resolution messages to high-bit resolution messages is adapted as iterations progress.

FIG.1

FIG.2A

From Channel → | DC _255_ | → | Remove Cyclic Prefix _260_ | → | S-to-P _265_ | → | Size N FFT _270_ | → | P-to-S _275_ | → | Channel Decod. & Demod. _280_ | → Data Out

_250_

# FIG.2B

116

305

310

RF
TRANSCEIVER

330

SPEAKER

325

RX
PROCESSING
CIRCUITRY

320

MICROPHONE

315

TX
PROCESSING
CIRCUITRY

345

I/O IF

340

MAIN
PROCESSOR

350

KEYPAD

DISPLAY

355

360

MEMORY

BASIC OPERATING
SYSTEM

361

APPLICATIONS

362

FIG.3

FIG.4A

FIG.4B

FIG.5

FIG.6

FIG.7

FIG.8

FIG.9

FIG.10

Ch. LLR[n-bits]

1010

Msg_m$_1$ [m- bits]

Msg_m$_{dv}$ [m- bits]

Q- Adder

Msg_a [k-bits]

Msg_qv$_1$ [m- bits]

Q- Subtractor

Msg_qv$_{dv}$ [m- bits]

Q- Subtractor

V N Processor 1

1012

1012

1002

1004

1006

FIG.11

1010

Ch. LLR[n- bits]

1014

Msg_m$_1$ [m- bits] → Q- Adder

Msg_m$_2$ [m- bits] → Q- Adder

1014

⋮ ⋮ ⋮ ⋮

Msg_m$_{dv}$ [m- bits] → Q- Adder

Msg_a [k- bits]

1004

1014

1002

FIG.12

FIG.13

EP 2 897 294 A1

FIG.14

FIG.15

$$\chi_{v_{j_{16}} \to c_{i,l}}(k) \qquad - \qquad \chi_{v_{j_1} \to c_{i,l}}(k)$$

CN Processor

↓ 1-bit $\qquad$ — $\qquad$ ↓ 1-bit

Early Stopping Processor — 1516

$$\left|\Psi_{v_{j_{16}} \to c_{i,l}}(k)\right| \qquad - \qquad \left|\Psi_{v_{j_1} \to c_{i,l}}(k)\right|$$

↓ 2-bit $\qquad$ — $\qquad$ ↓ 2-bit

Min1, Min2 Processor — 1518

$$\operatorname{sgn}\left(\Psi_{v_{j_{16}} \to c_{i,l}}(k)\right) \qquad - \qquad \operatorname{sgn}\left(\Psi_{v_{j_1} \to c_{i,l}}(k)\right)$$

↓ 1-bit $\qquad$ — $\qquad$ ↓ 1-bit

Sign Processor — 1520

FIG.16

FIG.17

FIG.18

Europäisches
Patentamt

European
Patent Office

Office européen
des brevets

# EUROPEAN SEARCH REPORT

Application Number

EP 15 15 1975

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DAESUN OH ET AL: "Min-Sum Decoder Architectures With Reduced Word Length for LDPC Codes", IEEE TRANSACTIONS ON CIRCUITS AND SYSTEMS I: REGULAR PAPERS, IEEE, US, vol. 57, no. 1, 1 January 2010 (2010-01-01), pages 105-115, XP011333589, ISSN: 1549-8328, DOI: 10.1109/TCSI.2009.2016171 | 1-14 | INV. H03M13/11 |
| Y | * page 105 - page 106 * * page 109 - page 113 * ----- | 15 | |
| Y | ZHANG J ET AL: "TWO-DIMENSIONAL CORRECTION FOR MIN-SUM DECODING OF IRREGULAR LDPC CODES", IEEE COMMUNICATIONS LETTERS, IEEE SERVICE CENTER, PISCATAWAY, NJ, US, vol. 10, no. 3, 1 March 2006 (2006-03-01), pages 180-182, XP001240591, ISSN: 1089-7798, DOI: 10.1109/LCOMM.2006.1603377 * page 182, left-hand column, paragraph 2 * ----- | 15 | |
| X | EP 2 083 519 A2 (SONY CORP [JP]) 29 July 2009 (2009-07-29) * paragraph [0078] - paragraph [0093]; figures 4,5,6,10 * ----- -/-- | 1,2,6,7 | TECHNICAL FIELDS SEARCHED (IPC) H03M |

The present search report has been drawn up for all claims

| Place of search | Date of completion of the search | Examiner |
|---|---|---|
| Munich | 5 May 2015 | Offer, Elke |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

## EUROPEAN SEARCH REPORT

Application Number

EP 15 15 1975

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | TAKASHI YOKOKAWA ET AL: "A High Performance and Programmable Decoder VLSI for Structured LDPC Codes", COMMUNICATIONS AND INFORMATION TECHNOLOGIES, 2006. PROC., IEEE INTERNATIONAL SYMPOSIUM ON COMMUNICATIONS AND INFORMATION TECHNOLOGY, ISCIT 2006, IEEE, PI, 18 October 2006 (2006-10-18), - 20 October 2006 (2006-10-20), pages 370-375, XP031068522, ISBN: 978-0-7803-9740-8 * the whole document * ----- | 1-15 | |
| A | EP 1 947 772 A1 (SONY CORP [JP]) 23 July 2008 (2008-07-23) * the whole document * ----- | 1-15 | |
| A | US 8 291 292 B1 (VARNICA NEDELJKO [US] ET AL) 16 October 2012 (2012-10-16) * the whole document * ----- | 1-15 | TECHNICAL FIELDS SEARCHED (IPC) |

The present search report has been drawn up for all claims

| Place of search | Date of completion of the search | Examiner |
|---|---|---|
| Munich | 5 May 2015 | Offer, Elke |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                    EP 15 15 1975

This annex lists the patent family members relating to the patent documents cited in the above-mentioned European search report.
The members are as contained in the European Patent Office EDP file on
The European Patent Office is in no way liable for these particulars which are merely given for the purpose of information.

05-05-2015

| Patent document cited in search report | | Publication date | Patent family member(s) | | Publication date |
|---|---|---|---|---|---|
| EP 2083519 | A2 | 29-07-2009 | EP | 2083519 A2 | 29-07-2009 |
| | | | JP | 4572937 B2 | 04-11-2010 |
| | | | JP | 2009177416 A | 06-08-2009 |
| | | | US | 2009187802 A1 | 23-07-2009 |
| EP 1947772 | A1 | 23-07-2008 | CN | 101310446 A | 19-11-2008 |
| | | | EP | 1947772 A1 | 23-07-2008 |
| | | | JP | 4293172 B2 | 08-07-2009 |
| | | | JP | 2007081601 A | 29-03-2007 |
| | | | KR | 20080045750 A | 23-05-2008 |
| | | | US | 2009304111 A1 | 10-12-2009 |
| | | | WO | 2007032251 A1 | 22-03-2007 |
| US 8291292 | B1 | 16-10-2012 | US | 8291292 B1 | 16-10-2012 |
| | | | US | 8769382 B1 | 01-07-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 8627166 B2
- US 20130061114 A1
- US 8458556 B2

### Non-patent literature cited in the description

- **R. G. GALLAGER.** Low-density parity-check codes. MIT Press, 1963
- **R. M. TANNER.** A recursive approach to low complexity codes. *IEEE Trans. on Inform. Theory,* September 1981, vol. 27, 533-547
- **J. THORPE.** Low-density parity-check (LDPC) codes constructed from protographs. *Tech. Rep,* August 2003, 42-154
- **D. DIVSALAR ; S. DOLINAR ; C. JONES.** Protograph LDPC codes over burst erasure channels. *IEEE Military Common. Conf., MILCOM,* 2006
- **G. LIVA ; M. CHIANI.** Protograph LDPC Codes Design Based on EXIT Analysis. *Protograph LDPC Codes Design Based on EXIT Analysis,* 2007